# EUROPEAN PATENT SPECIFICATION

(11) **EP 4 257 947 B1**
(45) Date of publication and mention of the grant of the patent: **11.02.2026**
(21) Application number: 23166435.0
(22) Date of filing: 04.04.2023
(51) Int. Cl.: G01M 5/00, G01M 7/00

(54) **VIBRATION TRANSDUCER WITH SIMPLIFIED CALIBRATION SENSORS FOR THE MONITORING OF A STATIC OR VIBRATING STRUCTURE**
SCHWINGUNGSWANDLER MIT VEREINFACHTEN KALIBRIERUNGSSENSOREN ZUR ÜBERWACHUNG EINER STATISCHEN ODER SCHWINGENDEN STRUKTUR
TRANSDUCTEUR DE VIBRATIONS À CAPTEURS DE CALIBRATION SIMPLIFIÉS POUR LA SURVEILLANCE D'UNE STRUCTURE STATIQUE OU VIBRANTE

(30) Priority: 07.04.2022 IT 202200006938
(43) Date of publication of application: 11.10.2023
(73) Proprietor: Casiroli, Renato, 20004 Arluno (MI) (IT)
(72) Inventor: Casiroli, Renato, 20004 Arluno (MI) (IT)
(74) Representative: Praxi Intellectual Property Milano

(56) References cited:
- JP-A- 2019 190 926
- KR-A- 20150 109 713
- US-A- 5 706 181
- US-A1- 2016 139 167

## Description

### BACKGROUND OF THE INVENTION

The present invention refers to a vibration transducer provided with simplified calibration sensors for the monitoring of a static or vibrating structure.

As is well known, the unavoidable deterioration of the physical and mechanical properties of materials, the obsolescence of the components, together with the usage of the existing building and the occurrence of natural events such as for example earthquakes, rains and landslides, require the research of monitoring systems allowing the state of health assessment of the structure and/or infrastructures under investigation, in order to carry out the necessary interventions for improving and/or restoring the safety conditions thereof and at the same time to reduce maintenance costs.

Structural monitoring is a process by which the existing building is characterised and by which some properties of the structure are identified obtaining information to be able to assess possible changes in the structural behaviour, such as damage of the material or of the structural elements, modifications in the behaviour of constraints and connection systems, or other modifications which may cause changes in the structure performance.

A structural monitoring system provides for the measurement of some quantities with time, using continuously a plurality of sensors (vibration, deformation, fissuring, corrosion, displacement, inclination, wind velocity, humidity and temperature sensors) placed in pre-established positions on the structure, in order to provide all the information needed to assess the structural behaviour of the structure under consideration.

A structural monitoring system allows to carry out the monitoring even during the construction phase, ensuring higher safety and control of the constructions.

Once completed the construction, in addition, the monitoring system allows the early detection of structural degradation compared with current checking methods, thus reducing high maintenance costs.

Current sensors for the monitoring of a static or vibrating structure have however several drawbacks, among which a considerable criticality in maintenance necessary to keep them reliable in use, due to the degradation of electric and mechanical parameters with time. In fact, current sensors use an electronic board, with vibration detection function, integrally formed with the sensors, the processor, and other electronic components, for example soldered on the board body, the board being subsequently attached on the structure to be monitored.

For this reason, the conventional sensors have the disadvantage that, if some calibrations or recalibrations have to be performed, there is the need to detach the electronic board with associated wiring from the case, and then remount a new electronic board, preserving the exact initial position of the sensor of the board with respect to the structure.

US 5 706 181 A discloses a sensor unit for controlling an occupant protection system of a motor vehicle.

JP 2019 190926 A relates to a structure monitoring device, provided with a sensor unit including an inertial sensor.

KR 2015 0109713 A discloses a printed circuit board assembly.

US 2016/139167 A1 concerns a system including a sensor and an electric cable.

### SUMMARY OF THE INVENTION

The aim of the present invention is to design a vibration transducer, allowing to calibrate and/or replace in an easy and quick way the integrated sensors installed.

Within this aim, an object of the invention is to provide a vibration transducer as defined in claim 1 for the monitoring of a static or vibrating structure, suitable to be calibrated even outside its installation site.

A further object of the invention is to provide a vibration transducer, which is suitable to simplify maintenance and recalibration interventions also after its installation, thus making up in a radical way for the degradation of its electric and mechanical parameters over time.

A further object of the invention is to design a vibration transducer, which ensures the stability of the coupling between the sensor module and the electronic board, even in presence of vibrations.

A further object of the invention is to provide a vibration transducer, which, in addition to preventing complex in situ performance of calibrations or recalibrations, allows to detach the electronic board with the associated wiring and to reassemble the whole thing in the exact initial position of the sensor on the structure.

This aim as well as these and other objects are achieved by the transducer of claim 1. Preferred embodiments of the transducer of the invention result from the remaining claims.

### BRIEF DESCRIPTION OF THE DRAWINGS

These and other objects, advantages and features result from the following description of the transducer system of the invention illustrated, by way of non-limiting example, in the figures of the attached drawings.

In these:

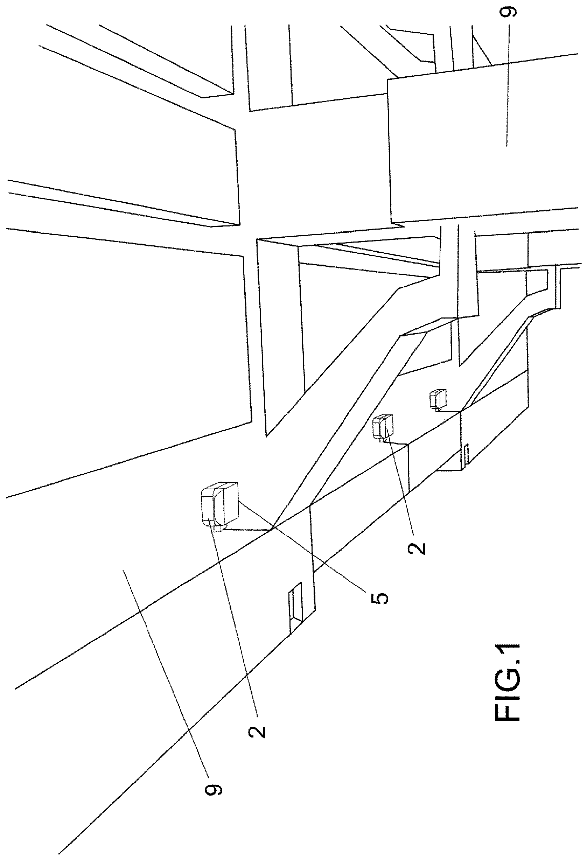

- Figure 1 represents an example of application of the transducer of the invention to a structure to be monitored;
- Figure 2 is a perspective view of the transducer of the invention, with the case in the open position, representative of the sensor module in a detached position from the electronic board;

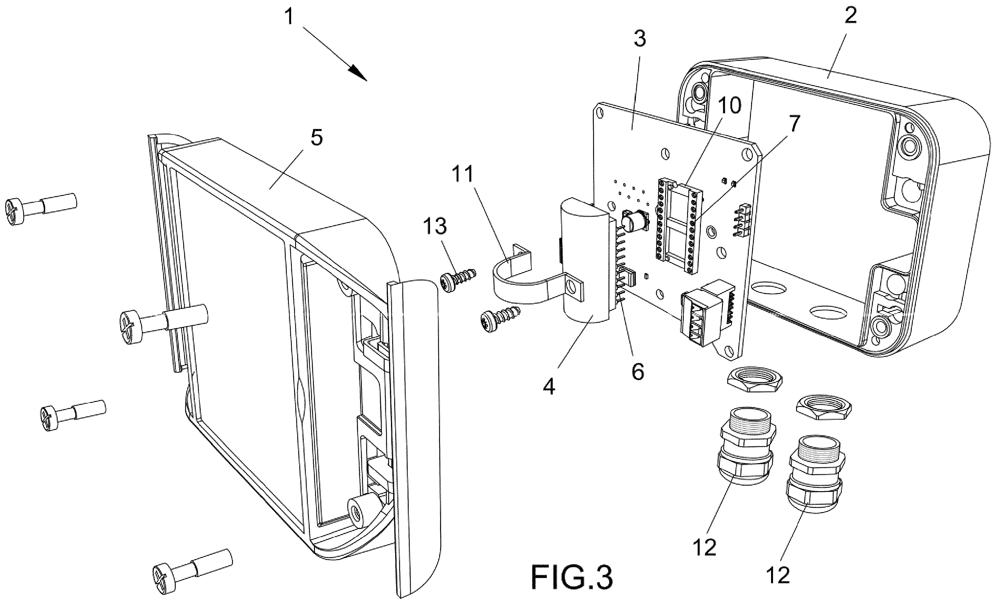

- Figure 3 is an exploded perspective view of the transducer of the invention;
- Figure 4 illustrates, partially in section, the socket of the transducer of the invention;
- Figure 5 illustrates in an exploded view the mounting solution of the sensor module on the socket of the transducer of the invention; and
- Figure 6 illustrates, partially in section, the coupling of the sensor module on the socket of the preceding figures.

### DETAILED DESCRIPTION OF THE PREFERRED EMBODIMENTS

With particular reference to the above described figures, the simplified calibration transducer for the monitoring of a static or vibrating structure of the invention is indicated as a whole with the numeral 1.

The transducer 1 comprises a case 2 suitable to be applied to the structure 9 to be monitored (in the illustrated example the arches of a bridge). The transducer 1 also has an electronic board 3 attached within the case 2 and a sensor module 4 associable to the electronic board 3. The case 2 has also a closing lid 5 thereof.

The sensor module 4 comprises first male coupling pins 6 for coupling with second female coupling means 7 present on the board 3, to allow the manual attachment and detachment of the sensor module 4 itself from the electronic board 3, facilitating in this way the sensor calibration interventions.

This solution allows to perform the calibrations or the recalibrations of the sensor 4, without the need to unmount the case 2 from its application site on the building to be monitored, or to detach from the case 2 the electronic board 3 with the associated wiring, and then being forced to reassemble the whole thing in the exact initial position of the sensor module 4 on the structure 9.

In this way the sensor part represented by the sensor module 4 is separated from the electronic board 3 and this allows to leave the electronic board 3 attached in the initial position thereof on the case 2, detaching only the sensor module 4 so that it can be replaced with a new sensor module calibrated in a correct way. The described operation also allows the advantage of preserving the pre-existing wiring between the transducer 1 and the associated monitoring system, which in fact do not need to be detached from the case body 2. This therefore allows to detach the sensor module 4 and to replace it with a previously calibrated one, or to position it back after the appropriate recalibration interventions, without having to remove the case or even the electronic board alone from the structure to be monitored.

In particular, according to the invention, the aforementioned female coupling means consist of housings 7 placed within the socket 10.

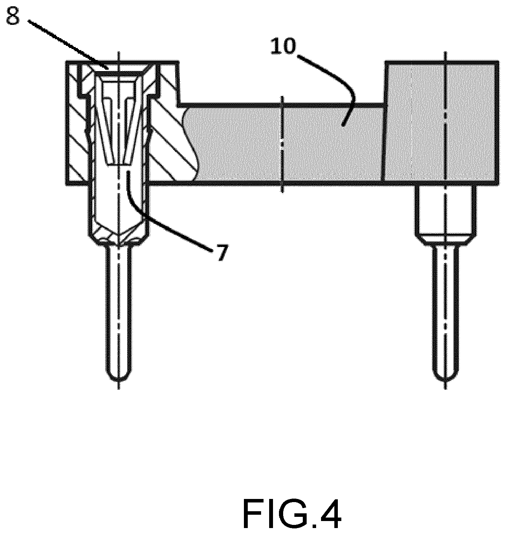

Figure 4 shows a sectional view of the socket 10 and the housing 7 for the respective male pin 6 of the sensor module 4. The socket 10 is of the DIL (Dual In Line) type which is provided with two parallel rows of housings 7 (in the present case two rows with twelve housings each). The housings 7 are of the turned type, having a conical inlet 8, which provides four points of contact with the male pins 6. The housings 7, with their four points of contact, ensure a precise engagement and a stable contact over time with the male pins 6. The desired reliability of the electrical connection is therefore ensured, even in presence of vibrations on which the transducer of the invention is called to act.

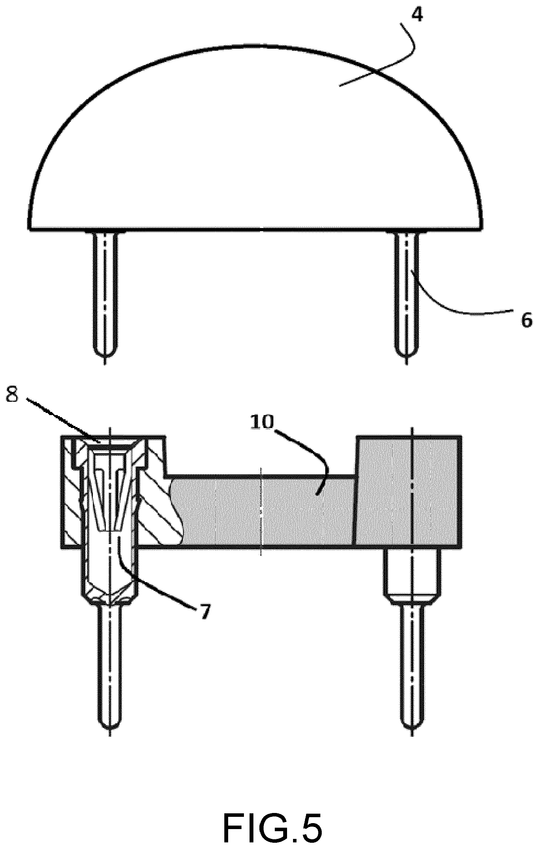

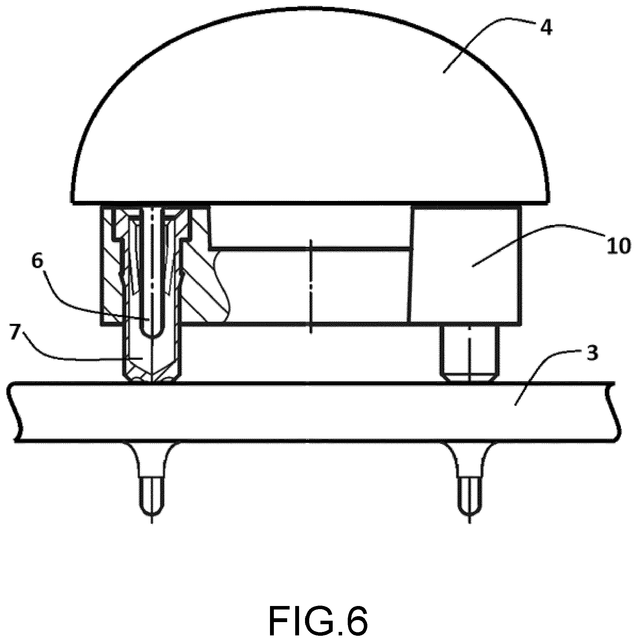

As already mentioned, therefore, as shown in particular in Figures 5 and 6, the coupling of the male pins 6 on the respective female housings 7 of the turned type, provides stability to the assembling of the sensor module 4 on the electronic board 3, even in presence of vibrations on which the transducer of the invention is called to act.

In particular, Figure 5 illustrates the insertion of the pins 6 of the sensor module 4 within the housings 7 of the DIL socket 10, while Figure 6 shows the sectional view of the coupling, that is achieved when the male pins 6 of the sensor module 4 engage within the corresponding housings 7 of the DIL socket 10. The plating of the housings 7, in addition, ensures optimal resistance to corrosion and oxidation.

The transducer of the invention also has a safety element 11 for preventing the unintentional detaching of the module 4 from the board 3, which consists of a metal clamp having a shape combined with that of the module 4 and which is attached to the board 3 by suitable screws 13.

In addition, the socket 10 is arranged in a position substantially central with respect to the board 3, so as to facilitate the manual operations of detachment and attachment to the board 3 itself and for an alignment with the cable glands 12.

Further, as the socket 10 is in an elevated position with respect to the electronic board 3, possible penetrations of liquids or other into the male pins and female housings are prevented.

Advantageously, the module 4 alone is coated with a resin suitable to prevent any damage of the circuits aboard thereof, in particular a resin protective against atmospheric agents and electrostatic charges by direct contact. The resin coating the module 4 allows even to the user who is unskilled in electronics not to damage the circuits aboard the module itself.

Conveniently, the male pins and female housings have a plating, suitable to ensure optimal resistance to corrosion and oxidation, while guaranteeing a precise engagement and a stable contact over time. Round contacts, in addition, simplify the soldering on the PCB and improve the resistance thereof.

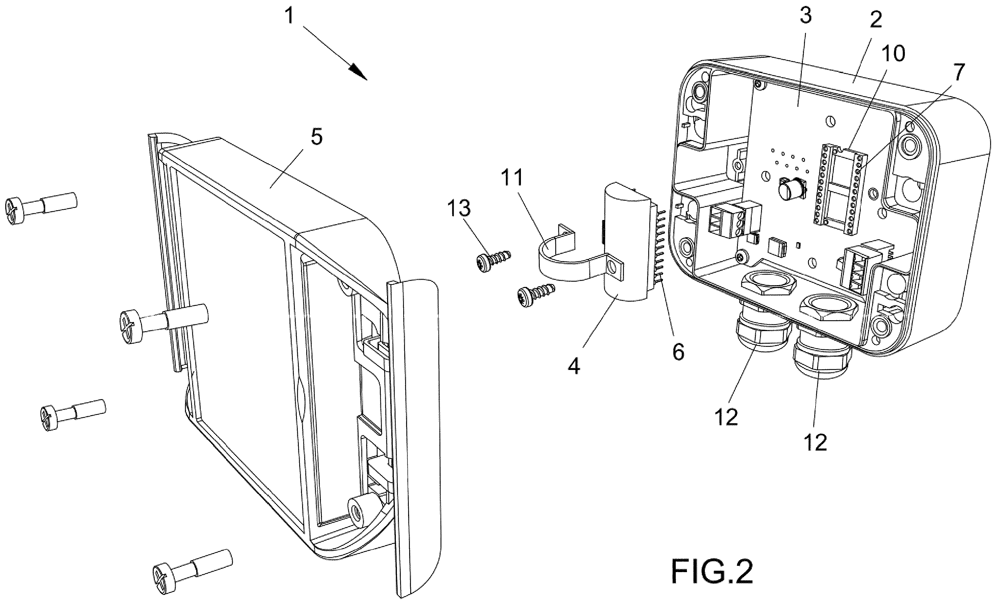

In the embodiment illustrated in Figure 2, the electronic board 3 may be left in position, together with the associated wiring within the case 2, extracting or removing the sensor module 4 alone to carry out its replacement.

In practice it has been observed that the invention allows the replacement of the sensor module 4 without any tool and following simple indications. This replacement as such provides a recalibration of the initial sensor.

In practice the materials used, as well as the dimensions, may be any according to requirements and to the state of the art.

It is also to be understood that the invention also extends to vibration transducers provided with multiple sensor modules 4.

## Claims

1. Vibration transducer (1), said transduce (1)
comprising a case (2) suitable to be applied to the structure (9) to be monitored, an electronic board (3) attached within said case, at least one sensor module (4) coupled with said electronic board, and a closing lid (5) of said case, **characterized in that** said sensor module (4) comprises first male pins (6) for coupling with second female coupling means (7) comprising a Dual-in-line (DIL) socket (10) present on said board (3) in order to manually attach and detach said sensor module (4) from said board (3) for the calibration thereof,
and **in that** the transducer (1) further comprises a safety element for preventing the unintentional detaching of the sensor module (4) from the electronic board (3), which consists of a metal clamp (11) having a shape combined with that of the sensor module (4) and which is attached to the electronic board (3) by suitable screws (13).

2. Transducer according to claim 1, **characterized in that** the sensor module (4) alone is coated with resin in order to prevent the damage of the circuits aboard said module, said resin being protective against atmospheric agents and electrostatic charges by direct contact.

## Patentansprüche

1. Schwingungswandler (1), der Wandler (1) umfassend ein Gehäuse (2), das geeignet ist, um an der zu überwachenden Struktur (9) angebracht zu werden, eine elektronische Platine (3), die innerhalb des Gehäuses befestigt ist, mindestens ein Sensormodul (4), das mit der elektronischen Platine gekoppelt ist, und einen Verschlussdeckel (5) des Gehäuses, **dadurch gekennzeichnet, dass** das Sensormodul (4) erste Steckerstifte (6) zum Koppeln mit zweiten Buchsenkupplungsmitteln (7) umfasst, umfassend einen Dual-in-line-Sockel (DIL-Sockel) (10), der auf der Platine (3) vorhanden ist, um das Sensormodul (4) an der Platine (3) für die Kalibrierung davon manuell zu befestigen und von dieser zu lösen, und **dass** der Wandler (1) ferner ein Sicherheitselement zum Verhindern des unbeabsichtigten Lösens des Sensormoduls (4) von der elektronischen Platine (3) umfasst, das aus einem Metallbügel (11) besteht, der eine mit der des Sensormoduls (4) kombinierte Form aufweist und der durch geeignete Schrauben (13) an der elektronischen Platine (3) befestigt ist.

2. Wandler nach Anspruch 1, **dadurch gekennzeichnet, dass** das Sensormodul (4) allein mit Harz beschichtet ist, um die Beschädigung der Schaltkreise an Bord des Moduls zu verhindern, wobei das Harz durch direkten Kontakt gegen atmosphärische Stoffe und elektrostatische Ladungen schützend wirkt.

## Revendications

1. Transducteur de vibrations (1), ledit transducteur (1) comprenant un boîtier (2) apte à être appliqué sur la structure (9) à surveiller, une carte électronique (3) fixée à l'intérieur dudit boîtier, au moins un module capteur (4) couplé à ladite carte électronique, et un couvercle de fermeture (5) dudit boîtier, **caractérisé en ce que** ledit module capteur (4) comprend des premières broches mâles (6) à coupler avec des seconds moyens de couplage femelles (7) composant une prise double en ligne (DIL) (10) présente sur ladite carte (3) afin d'attacher et de détacher manuellement ledit module capteur (4) de ladite carte (3) pour l'étalonnage de celui-ci, et **en ce que** le transducteur (1) comprend en outre un élément de sécurité pour empêcher le détachement involontaire du module de capteur (4) de la carte électronique (3), qui consiste en une pince métallique (11) ayant une forme combinée avec celle du module capteur (4) et qui est fixée à la carte électronique (3) par des vis appropriées (13).

2. Transducteur selon la revendication 1, **caractérisé en ce que** le module capteur (4) seul est revêtu de résine afin d'éviter la détérioration des circuits à l'intérieur dudit module, ladite résine étant protectrice contre les agents atmosphériques et les charges électrostatiques par contact direct.
